# EUROPEAN PATENT APPLICATION

(11) **EP 4 318 553 A2**
(43) Date of publication of application: **07.02.2024**
(21) Application number: 23185912.5
(22) Date of filing: 17.07.2023
(51) Int. Cl.: H01L 21/336, H01L 29/78, H01L 29/06, H01L 29/417, H01L 29/423

(54) **POWER SEMICONDUCTOR DEVICE HAVING COUNTER-DOPED REGIONS IN BOTH AN ACTIVE CELL REGION AND AN INACTIVE CELL REGION**

(30) Priority: 05.08.2022 US 202217882064
(71) Applicant: Infineon Technologies Austria AG, 9500 Villach (AT)
(72) Inventor: AMALI, Adam, Chandler 85286 (US); HENSON, Timothy, Mount Shasta 96067 (US); MALANI, Kishore Lakhmichand, El Segundo 90245 (US); HAASE, Robert, San Pedro 90732 (US); MA, Ling, Redondo Beach 90278 (US)
(74) Representative: Infineon Patent Department

(57) **Abstract**

A power semiconductor device includes: trench gate structures in an active cell region of a semiconductor substrate and extending into an inactive cell region of the semiconductor substrate that adjoins the active cell region; an electrically insulating material covering the trench gate structures; first contact openings in the electrically insulating material between adjacent trench gate structures in the active cell region; second contact openings in the electrically insulating material vertically aligned with the trench gate structures in the inactive cell region; first counter-doped regions between the adjacent trench gate structures in the active cell region and vertically aligned with the first contact openings; second counter-doped regions underneath the trench gate structures in the inactive cell region and vertically aligned with the second contact openings; first contacts in the first contact openings; and second contacts in the second contact openings. Methods of producing the power semiconductor device are also described.

## Description

### BACKGROUND

Power MOSFETs (metal-oxide-semiconductor field-effect transistors) are designed to handle significant voltages and are widely used in many types of power electronics applications such as power converters, power supplies, motor controllers, etc. Superjunction techniques, which are based on the idea of charge balancing in the transistor drift region, reduce the resistance of the drift region, which can be the largest resistance contributor in high voltage MOSFETs. Termination designs for superjunction MOSFETs use extra process steps to introduce dedicated termination structures. Such dedicated termination structures may be additional dedicated termination implants or trench isolation structures having the sole purpose of terminating the active circuits with no other active function. The addition of extra process steps to introduce dedicated termination structures adds cost, cycle time, and complexity to the process without adding any performance advantage.

Thus, there is a need for an improved termination design for superjunction MOSFETs.

### SUMMARY

According to an embodiment of a method of producing a power semiconductor device, the method comprises: forming a plurality of trench gate structures in an active cell region of a semiconductor substrate, the plurality of trench gate structures extending into an inactive cell region of the semiconductor substrate that adjoins the active cell region; covering the plurality of trench gate structures with an electrically insulating material; forming, using a common mask, first contact openings in the electrically insulating material between adjacent trench gate structures in the active cell region and second contact openings vertically aligned with the trench gate structures in the inactive cell region; and implanting, using a common implantation process, a dopant species into the semiconductor substrate through the first contact openings and the second contact openings to form first counter-doped regions between the adjacent trench gate structures in the active cell region and second counter-doped regions underneath the trench gate structures in the inactive cell region.

According to an embodiment of a power semiconductor device, the power semiconductor device comprises: a plurality of trench gate structures in an active cell region of a semiconductor substrate, the plurality of trench gate structures extending into an inactive cell region of the semiconductor substrate that adjoins the active cell region; an electrically insulating material covering the plurality of trench gate structures; first contact openings in the electrically insulating material between adjacent trench gate structures in the active cell region; second contact openings in the electrically insulating material vertically aligned with the trench gate structures in the inactive cell region; first counter-doped regions between the adjacent trench gate structures in the active cell region and vertically aligned with the first contact openings; second counter-doped regions underneath the trench gate structures in the inactive cell region and vertically aligned with the second contact openings; first contacts in the first contact openings; and second contacts in the second contact openings.

Those skilled in the art will recognize additional features and advantages upon reading the following detailed description, and upon viewing the accompanying drawings.

### BRIEF DESCRIPTION OF THE FIGURES

The elements of the drawings are not necessarily to scale relative to each other. Like reference numerals designate corresponding similar parts. The features of the various illustrated embodiments can be combined unless they exclude each other. Embodiments are depicted in the drawings and are detailed in the description which follows.
FIG. 1 illustrates a partial cross-sectional view of an embodiment of a power semiconductor device having first counter-doped regions in an active cell region of a semiconductor substrate and second counter-doped regions in an inactive cell region of the semiconductor substrate.
FIGS. 2A through 2E illustrate an embodiment of a method of producing the first counter-doped regions the second counter-doped regions of the power semiconductor device, in a region of the device where the inactive cell region of the semiconductor substrate adjoins the active cell region.
FIG. 3 illustrates cross-sectional and plan views of the power semiconductor device after formation of a patterned power metallization layer in a region where the inactive cell region of the semiconductor substrate adjoins the active cell region.
FIG. 4 illustrates cross-sectional and plan views of the power semiconductor device after formation of a patterned power metallization layer in a region where the inactive cell region of the semiconductor substrate adjoins the active cell region, according to another embodiment.
FIG. 5 illustrates a cross-sectional view of the power semiconductor device during an embodiment of a common implantation process shown in FIG. 2C.
FIG. 6 illustrates cross-sectional and plan views of the power semiconductor device after formation of a patterned power metallization layer in a region where the inactive cell region of the semiconductor substrate adjoins the active cell region, according to another embodiment.
FIG. 7 illustrates cross-sectional and plan views of the power semiconductor device after formation of a patterned power metallization layer in a region where the inactive cell region of the semiconductor substrate adjoins the active cell region, according to another embodiment.
FIGS. 8 through 12 illustrate respective plan views of the power semiconductor device after formation of the patterned power metallization layer and in a region where the inactive cell region of the semiconductor substrate adjoins the active cell region, according to additional embodiments.

### DETAILED DESCRIPTION

The embodiments described herein provide a termination design and process that uses deep charge balancing implants underneath gate bus contacts as an active component of the termination structure. By using a deep charge balance implant under a contact in combination with a contact into a gate trench, the gate oxide is protected from drain potential and drops the drain potential from the backside of the device before reaching the active surface. The embodiments described herein may be used with charge balanced (superjunction) medium voltage power MOSFETS, e.g., in the range of 30V to 60V to reduce the number of process steps, allowing cost of manufacture or wafer cost in silicon foundries to be reduced. In addition, improved yield may be realized by the self-aligned nature of the termination charge balancing structure to the cell structure.

Described next with reference to the figures are embodiments of the termination design and methods of implanting the termination design.

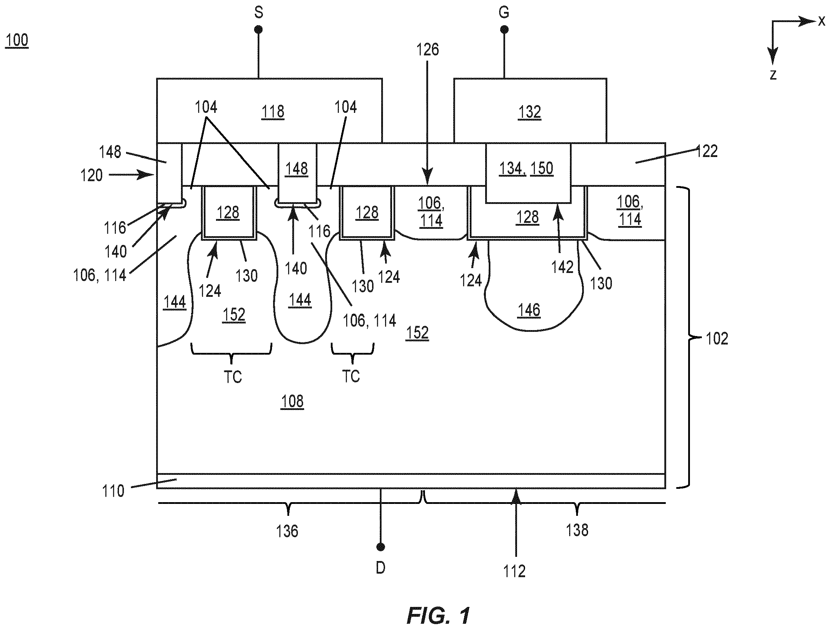

FIG. 1 illustrates a partial cross-sectional view of an embodiment of a power semiconductor device 100. The power semiconductor device 100 may be a power MOSFET, for example.

The power semiconductor device 100 includes a semiconductor substrate 102. The semiconductor substrate 102 comprises one or more semiconductor materials that are used to form transistor cells of the power transistor device such as, e.g., Si or SiC power MOSFET cells. For example, the semiconductor substrate 102 may comprise Si, silicon carbide (SiC), germanium (Ge), silicon germanium (SiGe), gallium nitride (GaN), gallium arsenide (GaAs), and the like. The semiconductor substrate 102 may be a bulk semiconductor material or may include one or more epitaxial layers grown on a bulk semiconductor material.

Two (2) adjacent transistor cells TC are shown in the partial cross-sectional view of FIG. 1. In general, the power semiconductor device 100 may have tens, hundreds, thousands, or even more transistors cells TC.

Each transistor cell TC includes a source region 104 of a first conductivity type and a body region 106 of a second conductivity type opposite the first conductivity type. The source region 104 of each transistor cell TC is separated from a drift zone 108 of the first conductivity type by the corresponding body region 106. In the case of a Si or SiC power MOSFET, a drain region 110 adjoins the drift zone 108 at the back surface 112 of the semiconductor substrate 102.

The first conductivity is n-type and the second conductivity type is p-type for an n-channel device whereas the first conductivity is p-type and the second conductivity type is n-type for a p-channel device. For either n-channel or p-channel devices, the source region 104 and the body region 106 included in the same semiconductor mesa 114 form part of a transistor cell TC and the transistor cells TC are electrically connected in parallel between source (S) and drain (D) terminals of the power semiconductor device 100 to form a power transistor such as a Si or SiC power MOSFET.

The body regions 106 may include a body contact region 116 of the second conductivity type and having a higher doping concentration than the body regions 106, to provide an ohmic connection with a source metallization 118 through a contact structure 120 that extends through an electrically insulating material 122 that separates the source metallization 118 from the underlying semiconductor substrate 102. The source regions 104 are also electrically connected to the source metallization 118 through the contact structure 120.

Stripe-shaped trench gate structures 124 extend from a front surface 126 of the semiconductor substrate 102 and into the substrate 102. The trench gate structures 124 are 'stripe-shaped' in that the trench gate structures 124 have a longest linear dimension in a direction which runs in and out of the page in FIG. 1 and parallel to the front surface 126 of the semiconductor substrate 102 and transverses the depth-wise direction (z direction in FIG. 1) of the semiconductor substrate 102.

Each trench gate structures 124 includes an electrically conductive material 128 such as polysilicon or a metal or metal alloy that forms a gate electrode and a gate dielectric insulating material 130 that separates the gate electrode material 128 from the surrounding semiconductor substrate 102. The gate electrode material 128 is electrically connected to a gate terminal 'G' of the power semiconductor device 100 through, e.g., metal gate runners 132 and respective contacts / vias 134 that extend through the electrically insulating material 122 that separates the source metallization 118 from the underlying semiconductor substrate 102.

The semiconductor substrate 102 has an active cell region 136 and an inactive cell region 138. The active cell region 136 of the semiconductor substrate 102 is the region of the semiconductor substrate 102 that includes fully functional transistor cells TC of the power semiconductor device 100. A fully functional transistor cell TC contributes to the main current flow of the power semiconductor device 100. The inactive cell region 138 of the semiconductor substrate 102 adjoins the active cell region 136. The inactive cell region 138 of the semiconductor substrate 102 is devoid of fully functional transistor cells TC and reduces electrical field crowding at termination. For example, the source regions 104 and/or body contacts may be omitted from the inactive cell region 138 of the semiconductor substrate 102.

In one embodiment, a breakdown voltage of the power semiconductor device 100 in the active cell region 136 of the semiconductor substrate 102 is in a range of 20V to 60V and the breakdown voltage of the power semiconductor device 100 in the inactive cell region 138 is greater than the breakdown voltage in the active cell region 136 by at least 2V. The maximum voltage across the gate dielectric insulating material 130 of the trench gate structures 124 is less than half the breakdown voltage in the inactive cell region 138, according to this embodiment.

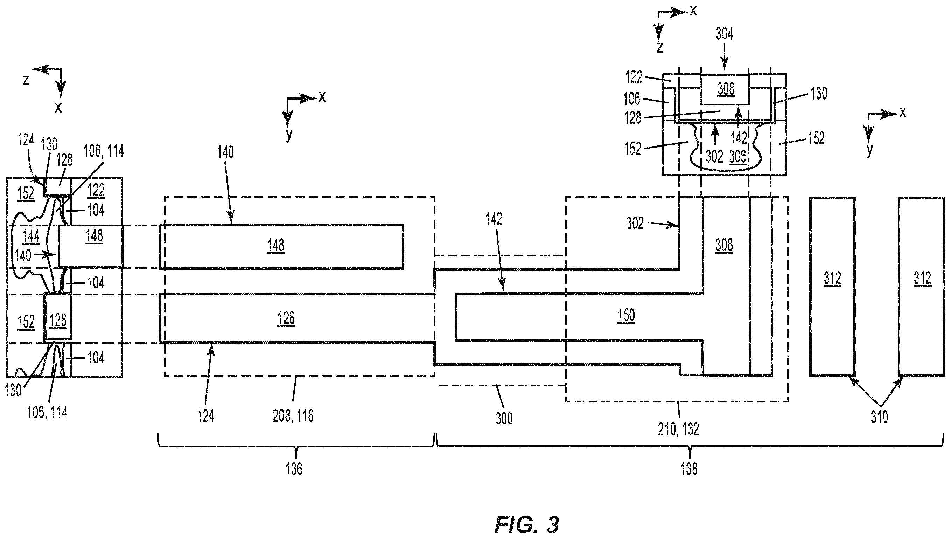

At least some of the trench gate structures 124 extend into the inactive cell region 138 of the semiconductor substrate 102. In the partial cross-sectional view of FIG. 1, the rightmost trench gate structure 124 is shown in the inactive cell region 138. This trench gate structure 124 and/or other trench gate structures 124 may extend into the inactive cell region 138 in the y lateral direction which is not shown in FIG. 1. This feature is shown in subsequent figures such as FIGS. 3, 4, and 6-12, each of which shows a top plan view of the power semiconductor device 100 in a region where the inactive cell region 138 of the semiconductor substrate 102 adjoins the active cell region 136.

Between adjacent trench gate structures 124 in the active cell region 136 of the semiconductor substrate 102, first contact openings 140 are formed in the electrically insulating material 122 that separates the source metallization 118 from the underlying semiconductor substrate 102. Second contact openings 142 are formed in the electrically insulating material and vertically aligned with the trench gate structures 124 in the inactive cell region 138.

First counter-doped regions 144 between the adjacent trench gate structures 124 in the active cell region 136 are vertically aligned with the first contact openings 140. Second counter-doped regions 146 underneath the trench gate structures 124 in the inactive cell region 138 are vertically aligned with the second contact openings 142. The first counter-doped regions 144 and the second counter-doped regions 146 are 'counter-doped' in that these regions 144, 146 have the opposite conductivity as the drift zone 108. First contacts 148 are disposed in the first contact openings and second contacts 150 are disposed in the second contact openings 142. The first contacts 148 and the second contacts 150 may comprise tungsten, for example.

A deep charge balance implant through the first contact openings 140 may be used to form the first counter-doped regions 144 and a shallower but wider charge balance implant through the second contact openings 142 may be used to form the second counter-doped regions 146. The contact dimensions may be varied to differentiate the dose of the counter doped implant in the active cell region 136 and the inactive cell region 138.

The first and second counter-doped regions 144, 148 form a superjunction structure with the adjoining regions 152 of the drift zone 108. The superjunction structure protects the gate dielectric insulating material 130 from the drain potential and drops the drain potential from the backside 112 of the power semiconductor device 100 before reaching the active (front) surface 126 of the semiconductor substrate 102.

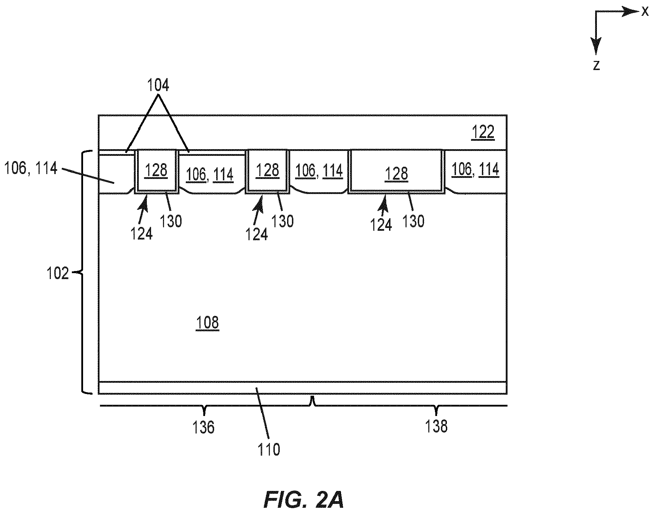

FIGS. 2A through 2E illustrate an embodiment of a method of producing the first counter-doped regions 144 in the active cell region 136 of the semiconductor substrate 102 and producing the second counter-doped regions 146 in the inactive cell region 138 of the semiconductor substrate 102, in a region where the inactive cell region 138 of the semiconductor substrate 102 adjoins the active cell region 136.

FIG. 2A illustrates the semiconductor substrate 102 after doping of the semiconductor substrate 102 to form the source and body regions 104, 106 and after forming the trench gate structures 124 in the semiconductor substrate 102. The trench gate structures 124 are covered with an electrically insulating material 122 such as an interlayer dielectric.

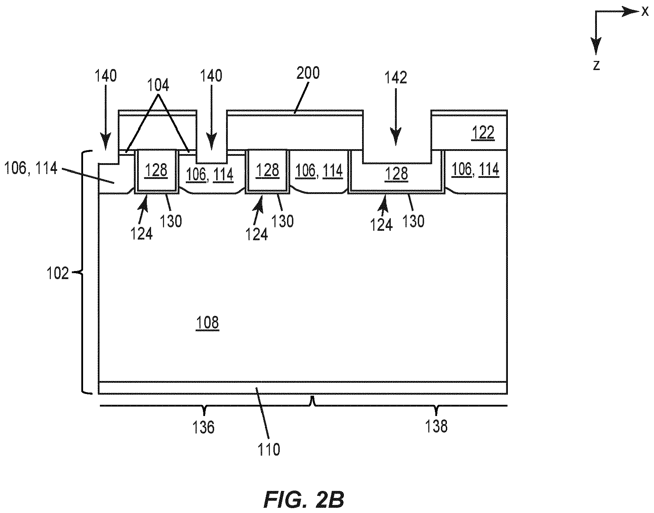

FIG. 2B illustrates using a common mask 200 to form the first contact openings 140 in the electrically insulating material 122 between adjacent trench gate structures 124 in the active cell region 136 and the second contact openings 142 vertically aligned (z direction in FIG. 2B) with the trench gate structures 124 in the inactive cell region 138. The first contact openings 140 and the second contact openings 142 may be formed using the common mask 200 by etching into the semiconductor substrate 102 between adjacent trench gate structures 124 in the active cell region 136 and into the gate electrode material 128 of the trench gate structures 124 in the inactive cell region 138. The common mask 200 may be, e.g., a photoresist.

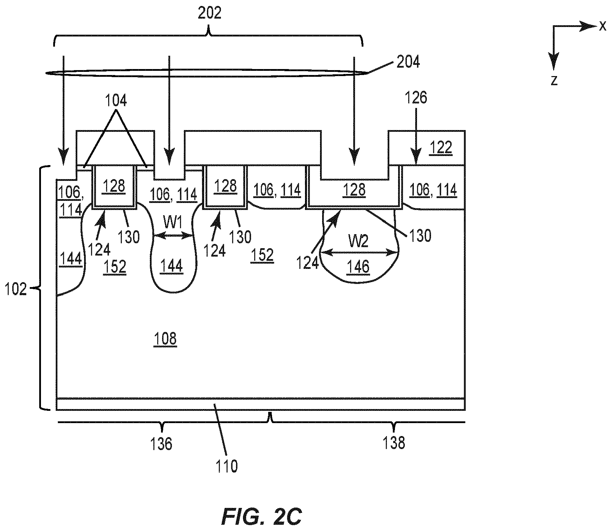

FIG. 2C illustrates using a common implantation process 202 to implant a dopant species 204 into the semiconductor substrate 102 through the first contact openings 140 and the second contact openings 142 to form the first counter-doped regions 144 between the adjacent trench gate structures 124 in the active cell region 136 and the second counter-doped regions 146 underneath the trench gate structures 124 in the inactive cell region 138. The dopant species 204 implanted into the semiconductor substrate 102 to form the first counter-doped regions 144 and the second counter-doped regions 146 has the opposite conductivity type as the drift zone 108. For example, in the case of an n-channel device and Si as the device material, the dopant species 204 may be boron and/or gallium. In the case of a p-channel device and Si as the device material, the dopant species 204 may be phosphorus and/or arsenic.

The second counter-doped regions 146 may have a different average width (W2 # W1) as compared to the first counter-doped regions 144, depending on the relative widths of the first contact openings 140 and the second contact openings 142. For example, the second contact openings 142 may be wider (W2 < W1) than the first contact openings 140 if the first counter-doped regions 144 extend deeper into the semiconductor substrate 102 than the second counter-doped regions 146, to ensure charge balancing in the drift zone 108.

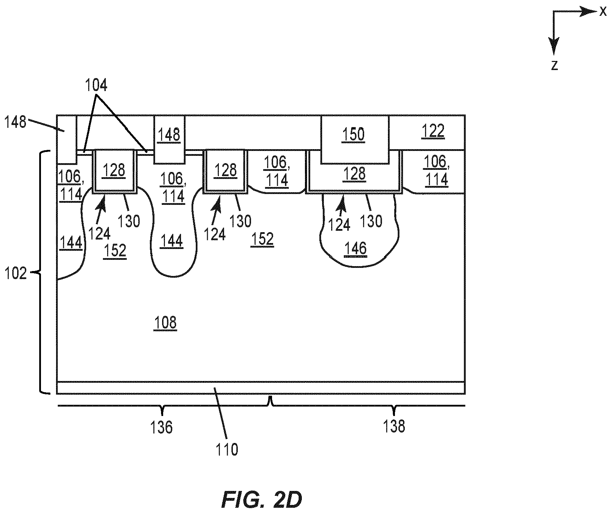

FIG. 2D illustrates, after the common implantation process 202, forming the first contacts 148 in the first contact openings 140 and the second contacts 150 in the second contact openings 142. The first contacts 148 and the second contacts 150 are at different potentials. For example, the first contacts 148 are at source potential and the second contacts 150 are at gate potential.

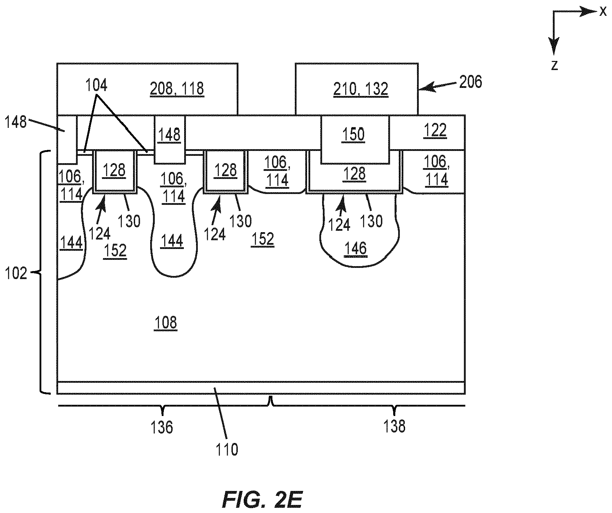

FIG. 2E illustrates a patterned power metallization layer 206 formed above the electrically insulating material 122 such that a first part 208 of the patterned power metallization layer 206 contacts the first contacts 148 and a second part 210 of the patterned power metallization layer 206 contacts the second contacts 150. The first part 208 of the patterned power metallization layer 206 may form the source metallization 118 shown in FIG. 1 and the second part 210 of the patterned power metallization layer 206 may form the metal gate runner 132 shown in FIG. 1.

FIG. 3 illustrates cross-sectional and plan views of the power semiconductor device 100 after formation of the patterned power metallization layer 206 in a region where the inactive cell region 138 of the semiconductor substrate 102 adjoins the active cell region 136. The lefthand side of FIG. 3 also illustrates a cross-sectional view of the power semiconductor device 100 in the active cell region 136 whereas the righthand side of FIG. 3 illustrates a cross-sectional view of the power semiconductor device 100 in the inactive cell region 138. The first part 208 of the patterned power metallization layer 206 / source metallization 118 and the second part 210 of the patterned power metallization layer 206 / metal gate runner 132 are disposed above the front surface 126 of the semiconductor substrate 102 and shown as dashed rectangles in FIG. 3 to provide an unobstructed view of the underlying trench gate structures 124 in both the active cell region 136 and the inactive cell region 138.

As shown in FIG. 3, the first contact openings 140 formed in the electrically insulating material 122 are disposed between adjacent trench gate structures 124 in the active cell region 136 and the second contact openings 142 formed in the electrically insulating material 122 are vertically aligned with the trench gate structures 124 in the inactive cell region 138. The first counter-doped regions 114 are formed between adjacent trench gate structures 124 in the active cell region 136 and vertically aligned with the first contact openings 140. The second counter-doped regions 146 underneath the trench gate structures 124 in the inactive cell region 138 are vertically aligned with the second contact openings 142. A passivation 300 may be formed on any part of the first contacts 148 and the second contacts 150 not covered by the patterned power metallization layer 206 / metal gate runner 132. The passivation 300 is shown as a dashed rectangle in FIG. 3 to provide an unobstructed view of the underlying second contact 150.

Also as shown in FIG. 3, the first contacts 148 are disposed in the first contact openings and the second contacts 150 are disposed in the second contact openings 142. The first contacts 148 and the second contacts 150 may be offset from one another in a lengthwise extension (x direction in FIG. 3) of the first contacts 148 and the second contacts 150.

In the inactive cell region 138 of the semiconductor substrate 102, at least some of the trench gate structures 124 may intersect a trench gate bus structure 302 that electrically interconnects the gate electrode material 128 of the trench gate structures 124. The trench gate bus structure 302 may have the same or similar configuration as the trench gate structures 124. Accordingly, the trench gate bus structure 302 may be formed concurrently with the trench gate structures 124 using the same trench etching and gate formation processes.

The same common mask 200 used to form the first contact openings 140 and the second contact openings 142 in the electrically insulating material 122 may be used to form an additional contact opening 304 in the electrically insulating material 122 and that is vertically aligned with the trench gate bus structure 302 in the inactive cell region 138. The common mask 200 is overlaid on the electrically insulating material 122 in the cross-sectional view shown in the righthand part of FIG. 3 to illustrate this feature, even though the contact opening etch process is performed earlier as shown in FIG. 2B.

The common implantation process 202 shown in FIG. 2C may be used to implant the dopant species 204 for counter-doping into the semiconductor substrate through the additional contact opening 304, to form an additional counter-doped region 306 underneath the trench gate bus structure 302 in the inactive cell region 138 and vertically aligned with the additional contact opening 304. This may involve implanting the dopant species 204 through a thinned / etched part of a gate electrode material 128 that remains in the trench gate bus structure 302 upon completion of the contact opening etch process. A contact material 308 such as tungsten may be deposited in the additional contact opening 304 after completion of the common implantation process 202, to form an adequate gate signal routing connection to the overlying second part 210 of the patterned power metallization layer 206 / metal gate runner 132. The contacts 148, 150, 308 may be formed using a common metal deposition and planarization process.

The power semiconductor device 100 may include one or more field termination trenches 310 in the inactive cell region 138 of the semiconductor substrate 102. An electrically conductive material 312 such as polysilicon or a metal or metal alloy disposed in the field termination trenches 310 may be electrically floating, i.e., not directly connected to an electric potential.

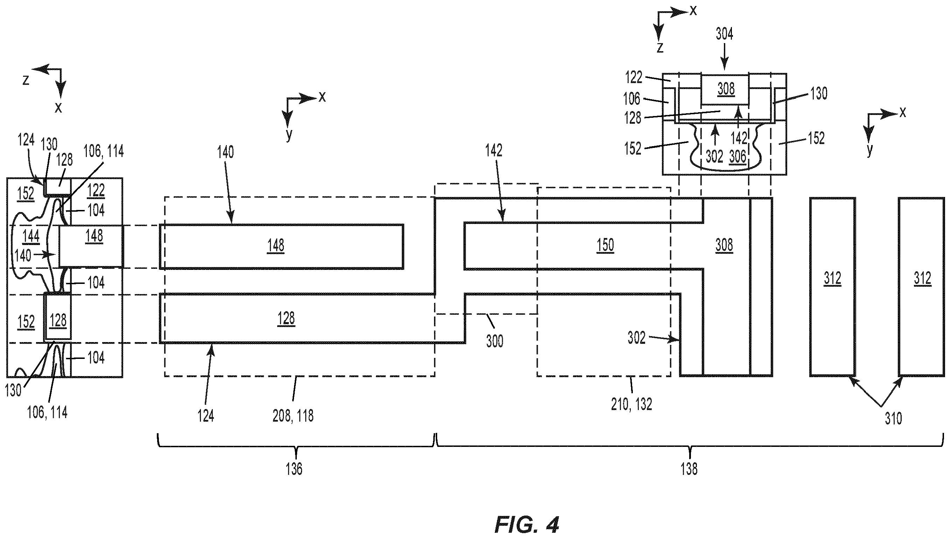

FIG. 4 illustrates cross-sectional and plan views of the power semiconductor device 100 after formation of the patterned power metallization layer 206 and in a region where the inactive cell region 138 of the semiconductor substrate 102 adjoins the active cell region 136, according to another embodiment. The embodiment shown in FIG. 4 is similar to the embodiment shown in FIG. 3. In FIG. 4, the first contacts 148 and the second contacts 150 are aligned with one another in a lengthwise extension (x direction in FIG. 4) of the first contacts 148 and the second contacts 150. Such a contact alignment may be realized by configuring the layout of the trench gate bus structure 302 accordingly in the inactive cell region 138 of the semiconductor substrate 102.

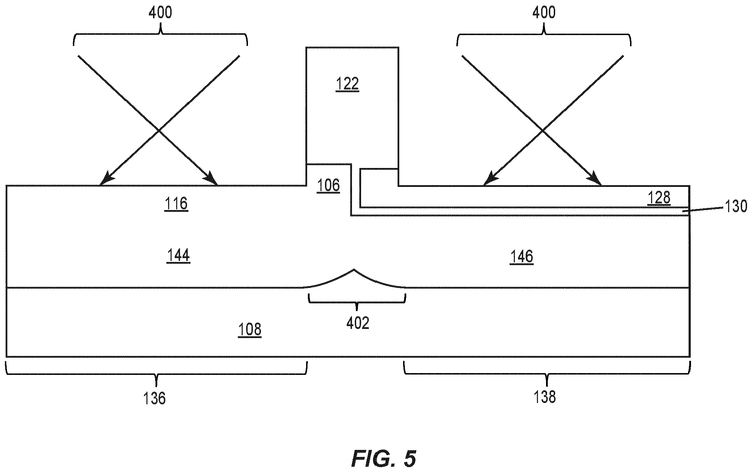

FIG. 5 illustrates a cross-sectional view of the power semiconductor device 100 during an embodiment of the common implantation process 202 shown in FIG. 2C. According to this embodiment, the common implantation process 202 includes an angled implant 400, e.g., at 45 degrees relative to the front surface 126 of the semiconductor substrate 102. The angled implant 400 results in the first counter-doped regions 144 and the second counter-doped regions 146 merging with one another along a border region 402 between the active cell region 136 and the inactive cell region 138 of the semiconductor substrate 102.

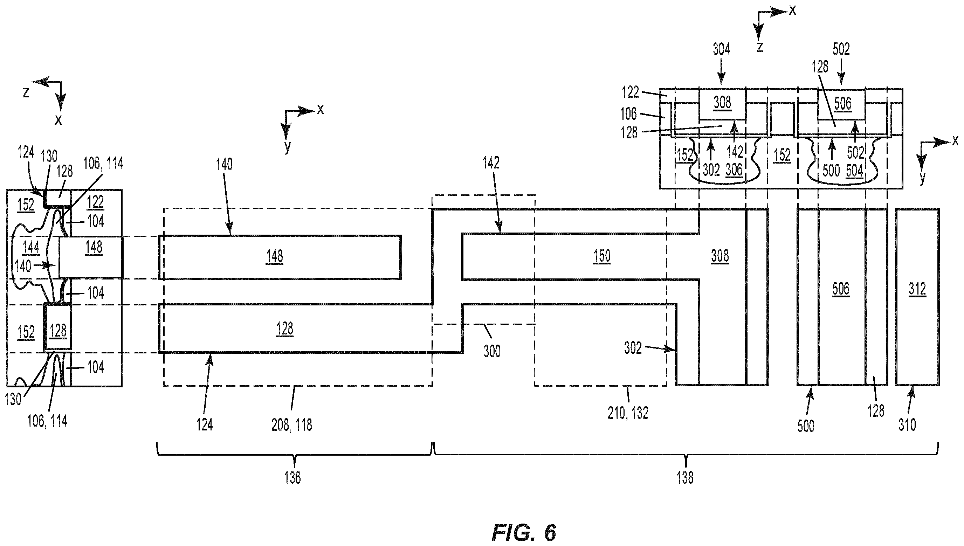

FIG. 6 illustrates cross-sectional and plan views of the power semiconductor device 100 after formation of the patterned power metallization layer 206 and in a region where the inactive cell region 138 of the semiconductor substrate 102 adjoins the active cell region 136, according to another embodiment. The embodiment shown in FIG. 6 is similar to the embodiment shown in FIG. 4. In FIG. 6, a trench shielding structure 500 is formed in the inactive cell region 138 of the semiconductor substrate 102. The trench shielding structure 500 laterally surrounds the trench gate structures 124 and is electrically floating. The trench shielding structure 500 may have the same or similar configuration as the trench gate structures 124. Accordingly, the trench shielding structure 500 may be formed concurrently with the trench gate structures 124 using the same trench etching and gate formation processes.

The same common mask 200 used to form the first contact openings 140 and the second contact openings 142 in the electrically insulating material 122 may be used to form an additional contact opening 502 in the electrically insulating material 122 and that is vertically aligned with the trench shielding structure 500 in the inactive cell region 138. The common mask 200 is overlaid on the electrically insulating material 122 in the cross-sectional view shown in the righthand part of FIG. 6 to illustrate this feature, even though the contact opening etch process is performed earlier as shown in FIG. 2B.

The common implantation process 202 shown in FIG. 2C may be used to implant the dopant species 204 for counter-doping into the semiconductor substrate through the additional contact opening 502, to form an additional counter-doped region 504 underneath the trench shielding structure 500 in the inactive cell region 138 and vertically aligned with the additional contact opening 502. This may involve implanting the dopant species 204 through a thinned / etched part of a gate electrode material 128 that remains in the trench shielding structure 500 upon completion of the contact opening etch process. A contact material 506 such as tungsten may be formed in the additional contact opening 502 after completion of the common implantation process 202, e.g., as part of a common metal deposition and planarization process. The contact material 506 and any remaining gate electrode material 128 in the trench shielding structure 500 is not directly connected to an electric potential and therefore is electrically floating.

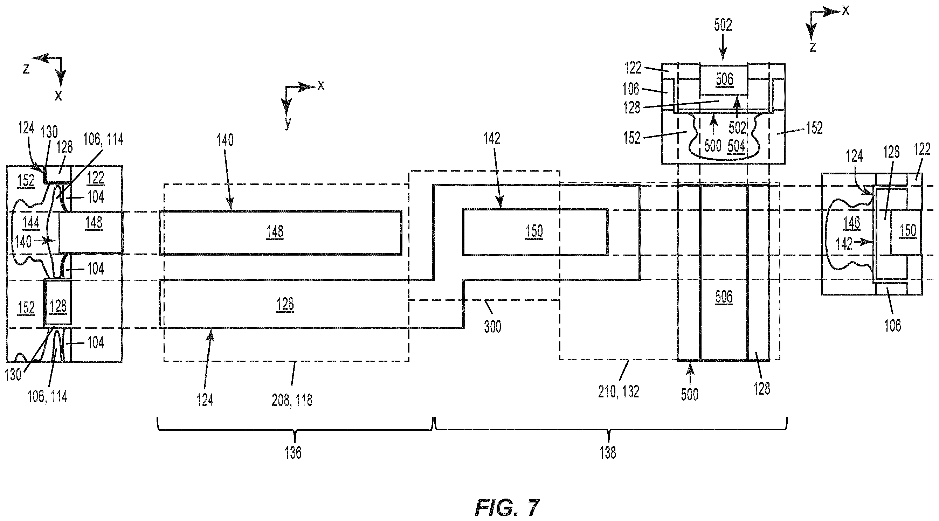

FIG. 7 illustrates cross-sectional and plan views of the power semiconductor device 100 after formation of the patterned power metallization layer 206 and in a region where the inactive cell region 138 of the semiconductor substrate 102 adjoins the active cell region 136, according to another embodiment. The embodiment shown in FIG. 7 is similar to the embodiment shown in FIG. 6. In FIG. 7, the inactive cell region 138 of the semiconductor substrate 102 is devoid of a trench gate bus structure 302 and field termination trenches 310. Also, the contact material 506 and any remaining gate electrode material 128 in the trench shielding structure 500 is electrically connected to the second part 210 of the patterned power metallization layer 206 / metal gate runner 132.

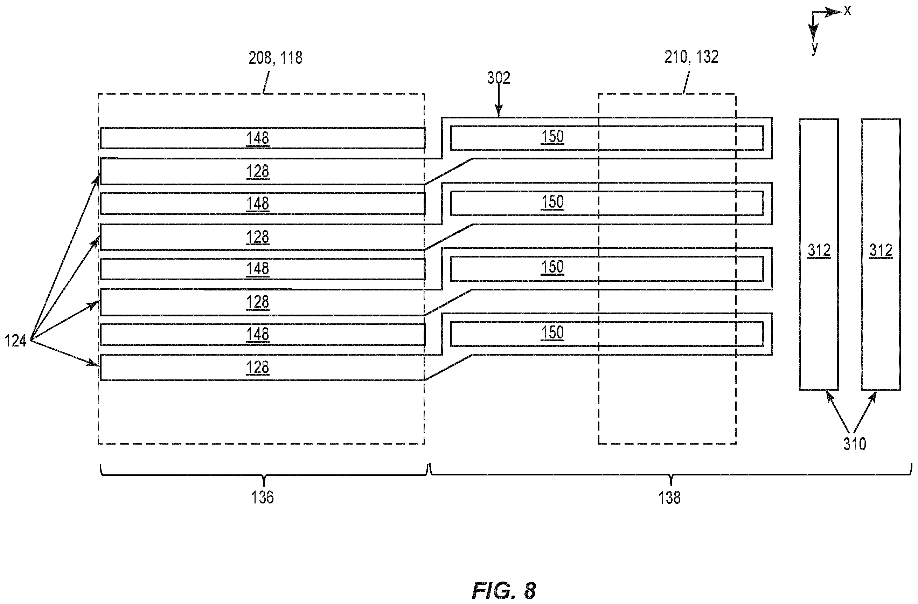

FIG. 8 illustrates a plan view of the power semiconductor device 100 after formation of the patterned power metallization layer 206 and in a region where the inactive cell region 138 of the semiconductor substrate 102 adjoins the active cell region 136, according to another embodiment. In FIG. 8, the first contacts 148 and the second contacts 150 are aligned with one another in a lengthwise extension (x direction in FIG. 4) of the first contacts 148 and the second contacts 150. Such a contact alignment may be realized by shifting the position of the trench gate structures 124 in the y lateral direction as the trench gate structures 124 transition into the inactive cell region 138 of the semiconductor substrate 102.

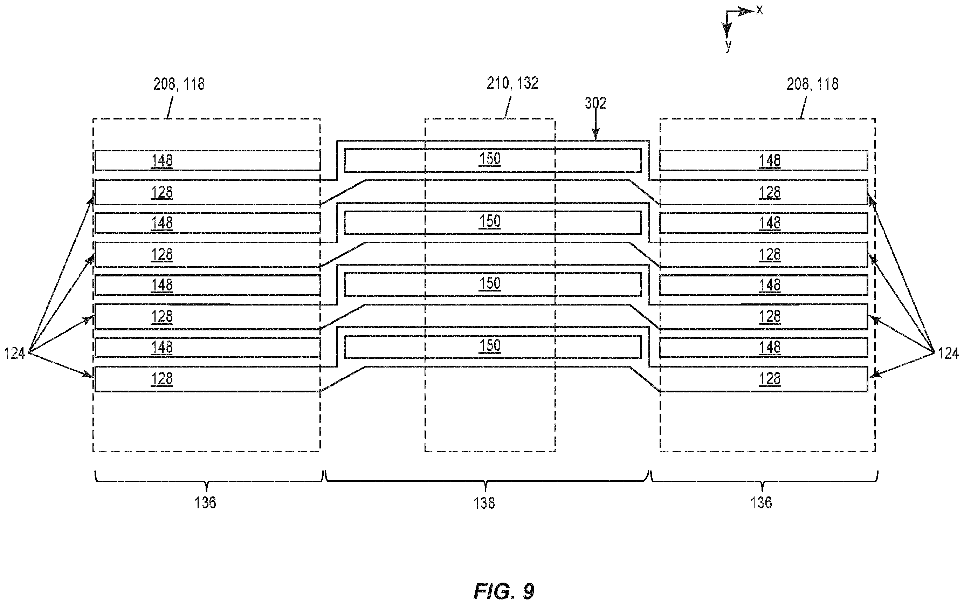

FIG. 9 illustrates a plan view of the power semiconductor device 100 after formation of the patterned power metallization layer 206 and in a region where the inactive cell region 138 of the semiconductor substrate 102 adjoins the active cell region 136, according to another embodiment. The embodiment shown in FIG. 9 is similar to the embodiment shown in FIG. 8. In FIG. 9, the trench gate bus structure 302 and the second part 210 of the patterned power metallization layer 206 / metal gate runner 132 are disposed in the center of the chip (die). The first contacts 148 and the second contacts 150 are aligned with one another in a lengthwise extension (x direction in FIG. 4) of the first contacts 148 and the second contacts 150 at both ends of the trench gate bus structure 302. Such a contact alignment may be realized by shifting the position of the trench gate structures 124 in the y lateral direction as the trench gate structures 124 transition into the inactive cell region 138 of the semiconductor substrate 102 at one end of the trench gate bus structure 302 and inversing the shift as the trench gate structures 124 transition out of the inactive cell region 138 at the opposite end of the trench gate bus structure 302.

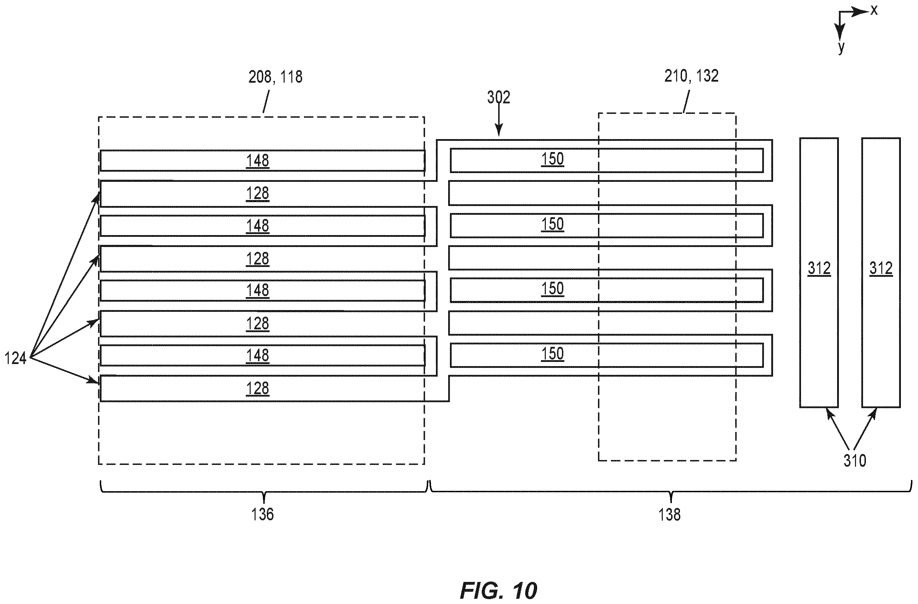

FIG. 10 illustrates a plan view of the power semiconductor device 100 after formation of the patterned power metallization layer 206 and in a region where the inactive cell region 138 of the semiconductor substrate 102 adjoins the active cell region 136, according to another embodiment. The embodiment shown in FIG. 10 is similar to the embodiment shown in FIG. 8. In FIG. 9, the gate electrode material 128 in the trench gate structures 124 is interconnected at the ends of the trench gate structures 124 which extend into the inactive cell region 138 of the semiconductor substrate 102.

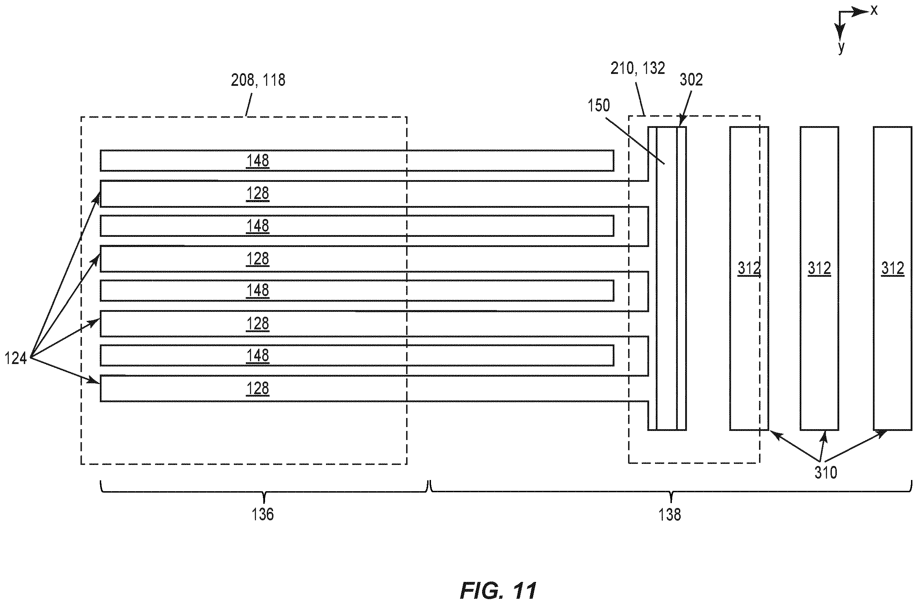

FIG. 11 illustrates a plan view of the power semiconductor device 100 after formation of the patterned power metallization layer 206 and in a region where the inactive cell region 138 of the semiconductor substrate 102 adjoins the active cell region 136, according to another embodiment. FIG. 11 corresponds to the embodiment shown in FIG. 3, but with additional trench gate structures 124.

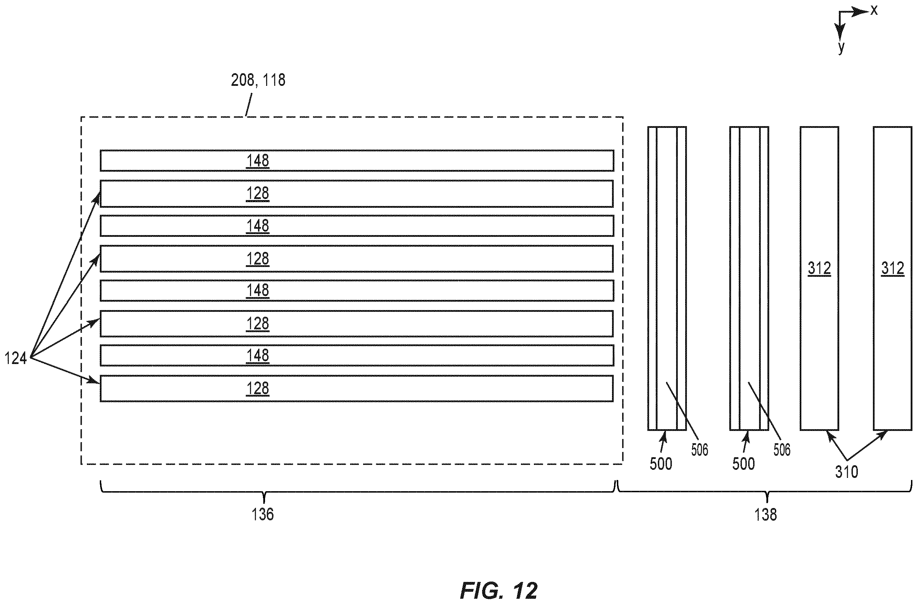

FIG. 12 illustrates a plan view of the power semiconductor device 100 after formation of the patterned power metallization layer 206 and in a region where the inactive cell region 138 of the semiconductor substrate 102 adjoins the active cell region 136, according to another embodiment. FIG. 12 corresponds to the embodiment shown in FIG. 7, but with an additional electrically floating trench shielding structure 500 and field termination trenches 310.

Although the present disclosure is not so limited, the following numbered examples demonstrate one or more aspects of the disclosure.

Example 1. A method of producing a power semiconductor device, the method comprising: forming a plurality of trench gate structures in an active cell region of a semiconductor substrate, the plurality of trench gate structures extending into an inactive cell region of the semiconductor substrate that adjoins the active cell region; covering the plurality of trench gate structures with an electrically insulating material; forming, using a common mask, first contact openings in the electrically insulating material between adjacent trench gate structures in the active cell region and second contact openings vertically aligned with the trench gate structures in the inactive cell region; and implanting, using a common implantation process, a dopant species into the semiconductor substrate through the first contact openings and the second contact openings to form first counter-doped regions between the adjacent trench gate structures in the active cell region and second counter-doped regions underneath the trench gate structures in the inactive cell region.

Example 2. The method of example 1, further comprising: after the common implantation process, forming first contacts in the first contact openings and second contacts in the second contact openings, wherein the first contacts and the second contacts are at different potentials.

Example 3. The method of example 2, further comprising: forming a patterned power metallization layer above the electrically insulating material such that a first part of the patterned power metallization layer contacts the first contacts and a second part of the patterned power metallization layer partly contacts the second contacts; and forming a passivation on any part of the first contacts and the second contacts not covered by the patterned power metallization layer.

Example 4. The method of any of examples 1 through 3, wherein forming the first contact openings and the second contact openings comprises: etching into the semiconductor substrate between the adjacent trench gate structures in the active cell region and into a gate electrode material of the trench gate structures in the inactive cell region.

Example 5. The method of any of examples 1 through 4, wherein in the inactive cell region, the plurality of trench gate structures intersect a trench gate bus structure that electrically interconnects a gate electrode material of the trench gate structures.

Example 6. The method of example 5, further comprising: forming, using the common mask, a third contact opening vertically aligned with the trench gate bus structure in the inactive cell region; and implanting, using the common implantation process, the dopant species into the semiconductor substrate through the third contact opening to counter-dope the semiconductor substrate underneath the trench gate bus structure in the inactive cell region.

Example 7. The method of any of examples 1 through 6, wherein the first counter-doped regions and the second counter-doped regions merge with one another along a border region between the active cell region and the inactive cell region.

Example 8. The method of any of examples 1 through 7, wherein the dopant species is implanted into the semiconductor substrate through the first contact openings and the second contact openings at an angle relative to a first main surface of the semiconductor substrate.

Example 9. The method of any of examples 1 through 8, further comprising: forming a trench shielding structure in the inactive cell region and that laterally surrounds the plurality of trench gate structures, wherein the trench shielding structure is electrically floating; forming, using the common mask, a third contact opening vertically aligned with the trench shielding structure in the inactive cell region; and implanting, using the common implantation process, the dopant species into the semiconductor substrate through the third contact opening to counter-dope the semiconductor substrate underneath the trench shielding structure in the inactive cell region.

Example 10. The method of any of examples 1 through 9, further comprising: forming a trench gate bus structure in the inactive cell region; forming, using the common mask, a third contact opening vertically aligned with the trench gate bus structure in the inactive cell region; implanting, using the common implantation process, the dopant species into the semiconductor substrate through the third contact opening to counter-dope the semiconductor substrate underneath the trench gate bus structure in the inactive cell region; and electrically connecting a metal line in the trench gate bus structure to gate electrodes in the plurality of trench gate structures.

Example 11. The method of any of examples 1 through 10, further comprising: forming a trench structure in the inactive cell region; forming, using the common mask, a third contact opening vertically aligned with the trench structure in the inactive cell region; and implanting, using the common implantation process, the dopant species into the semiconductor substrate through the third contact opening to counter-dope the semiconductor substrate underneath the trench structure in the inactive cell region, wherein the counter-doped semiconductor substrate underneath the trench structure in the inactive cell region is electrically floating.

Example 12. A power semiconductor device, comprising: a plurality of trench gate structures in an active cell region of a semiconductor substrate, the plurality of trench gate structures extending into an inactive cell region of the semiconductor substrate that adjoins the active cell region; an electrically insulating material covering the plurality of trench gate structures; first contact openings in the electrically insulating material between adjacent trench gate structures in the active cell region; second contact openings in the electrically insulating material vertically aligned with the trench gate structures in the inactive cell region; first counter-doped regions between the adjacent trench gate structures in the active cell region and vertically aligned with the first contact openings; second counter-doped regions underneath the trench gate structures in the inactive cell region and vertically aligned with the second contact openings; first contacts in the first contact openings; and second contacts in the second contact openings.

Example 13. The power semiconductor device of example 12, wherein the first contacts and the second contacts are aligned with one another in a lengthwise extension of the first contacts and the second contacts.

Example 14. The power semiconductor device of example 12, wherein the first contacts and the second contacts are offset from one another in a lengthwise extension of the first contacts and the second contacts.

Example 15. The power semiconductor device of any of examples 12 through 14, further comprising: a patterned power metallization layer above the electrically insulating material and comprising a first part that contacts the first contacts and a second part that contacts the second contacts; and a passivation covering any part of the first contacts and the second contacts not covered by the patterned power metallization layer.

Example 16. The power semiconductor device of any of examples 12 through 15, wherein the first contact openings are etched into the semiconductor substrate between the adjacent trench gate structures in the active cell region, and wherein the second contact openings are etched into a gate electrode material of the trench gate structures in the inactive cell region.

Example 17. The power semiconductor device of any of examples 12 through 16, wherein in the inactive cell region, the plurality of trench gate structures intersect a trench gate bus structure that electrically interconnects a gate electrode material of the trench gate structures, and wherein the power semiconductor device further comprises: a third contact opening in the electrically insulating material that is vertically aligned with the trench gate bus structure in the inactive cell region; and a third counter-doped region underneath the trench gate bus structure in the inactive cell region and vertically aligned with the third contact opening.

Example 18. The power semiconductor device of any of examples 12 through 17, wherein the first counter-doped regions and the second counter-doped regions merge with one another along a border region between the active cell region and the inactive cell region.

Example 19. The power semiconductor device of any of examples 12 through 18, further comprising: a trench shielding structure in the inactive cell region and that laterally surrounds the plurality of trench gate structures, wherein the trench shielding structure is electrically floating; a third contact opening in the electrically insulating material that is vertically aligned with the trench shielding structure in the inactive cell region; and a third counter-doped region underneath the trench shielding structure in the inactive cell region and vertically aligned with the third contact opening.

Example 20. The power semiconductor device of any of examples 12 through 19, further comprising: a trench gate bus structure in the inactive cell region; a third contact opening in the electrically insulating material that is vertically aligned with the trench gate bus structure in the inactive cell region; and a third counter-doped region underneath the trench gate bus structure in the inactive cell region and vertically aligned with the third contact opening, wherein a metal line in the trench gate bus structure is electrically connected to gate electrodes in the plurality of trench gate structures.

Example 21. The power semiconductor device of any of examples 12 through 20, wherein a breakdown voltage of the power semiconductor device in the active cell region is in a range of 20V to 60V, wherein the breakdown voltage of the power semiconductor device in the inactive cell region is greater than the breakdown voltage in the active cell region by at least 2V, and wherein a maximum voltage across a gate dielectric insulating material of the plurality of trench gate structures is less than half the breakdown voltage in the inactive cell region.

Example 22. The power semiconductor device of any of examples 12 through 21, further comprising: a trench structure in the inactive cell region; a third contact opening vertically aligned with the trench structure in the inactive cell region; and a third counter-doped region underneath the trench structure in the inactive cell region and vertically aligned with the third contact opening, wherein the third counter-doped semiconductor is electrically floating.

Terms such as "first", "second", and the like, are used to describe various elements, regions, sections, etc. and are also not intended to be limiting. Like terms refer to like elements throughout the description.

As used herein, the terms "having", "containing", "including", "comprising" and the like are open ended terms that indicate the presence of stated elements or features, but do not preclude additional elements or features. The articles "a", "an" and "the" are intended to include the plural as well as the singular, unless the context clearly indicates otherwise.

It is to be understood that the features of the various embodiments described herein may be combined with each other, unless specifically noted otherwise.

Although specific embodiments have been illustrated and described herein, it will be appreciated by those of ordinary skill in the art that a variety of alternate and/or equivalent implementations may be substituted for the specific embodiments shown and described without departing from the scope of the present invention. This application is intended to cover any adaptations or variations of the specific embodiments discussed herein. Therefore, it is intended that this invention be limited only by the claims and the equivalents thereof.

## Claims

1. A method of producing a power semiconductor device, the method comprising:
forming a plurality of trench gate structures in an active cell region of a semiconductor substrate, the plurality of trench gate structures extending into an inactive cell region of the semiconductor substrate that adjoins the active cell region;
covering the plurality of trench gate structures with an electrically insulating material;
forming, using a common mask, first contact openings in the electrically insulating material between adjacent trench gate structures in the active cell region and second contact openings vertically aligned with the trench gate structures in the inactive cell region; and
implanting, using a common implantation process, a dopant species into the semiconductor substrate through the first contact openings and the second contact openings to form first counter-doped regions between the adjacent trench gate structures in the active cell region and second counter-doped regions underneath the trench gate structures in the inactive cell region.

2. The method of claim 1, further comprising:
after the common implantation process, forming first contacts in the first contact openings and second contacts in the second contact openings,
wherein the first contacts and the second contacts are at different potentials.

3. The method of claim 2, further comprising:
forming a patterned power metallization layer above the electrically insulating material such that a first part of the patterned power metallization layer contacts the first contacts and a second part of the patterned power metallization layer partly contacts the second contacts; and
forming a passivation on any part of the first contacts and the second contacts not covered by the patterned power metallization layer.

4. The method of claim 1, wherein forming the first contact openings and the second contact openings comprises:
etching into the semiconductor substrate between the adjacent trench gate structures in the active cell region and into a gate electrode material of the trench gate structures in the inactive cell region.

5. The method of claim 1, wherein in the inactive cell region, the plurality of trench gate structures intersect a trench gate bus structure that electrically interconnects a gate electrode material of the trench gate structures; and/or further comprising:
forming, using the common mask, a third contact opening vertically aligned with the trench gate bus structure in the inactive cell region; and
implanting, using the common implantation process, the dopant species into the semiconductor substrate through the third contact opening to counter-dope the semiconductor substrate underneath the trench gate bus structure in the inactive cell region.

6. The method of claim 1,
wherein the first counter-doped regions and the second counter-doped regions merge with one another along a border region between the active cell region and the inactive cell region; and/or
wherein the dopant species is implanted into the semiconductor substrate through the first contact openings and the second contact openings at an angle relative to a first main surface of the semiconductor substrate.

7. The method of claim 1, further comprising:
forming a trench shielding structure in the inactive cell region and that laterally surrounds the plurality of trench gate structures, wherein the trench shielding structure is electrically floating;
forming, using the common mask, a third contact opening vertically aligned with the trench shielding structure in the inactive cell region; and
implanting, using the common implantation process, the dopant species into the semiconductor substrate through the third contact opening to counter-dope the semiconductor substrate underneath the trench shielding structure in the inactive cell region.

8. The method of claim 1, further comprising:
forming a trench gate bus structure in the inactive cell region;
forming, using the common mask, a third contact opening vertically aligned with the trench gate bus structure in the inactive cell region;
implanting, using the common implantation process, the dopant species into the semiconductor substrate through the third contact opening to counter-dope the semiconductor substrate underneath the trench gate bus structure in the inactive cell region; and
electrically connecting a metal line in the trench gate bus structure to gate electrodes in the plurality of trench gate structures.

9. The method of claim 1, further comprising:
forming a trench structure in the inactive cell region;
forming, using the common mask, a third contact opening vertically aligned with the trench structure in the inactive cell region; and
implanting, using the common implantation process, the dopant species into the semiconductor substrate through the third contact opening to counter-dope the semiconductor substrate underneath the trench structure in the inactive cell region,
wherein the counter-doped semiconductor substrate underneath the trench structure in the inactive cell region is electrically floating.

10. A power semiconductor device, comprising:
a plurality of trench gate structures in an active cell region of a semiconductor substrate, the plurality of trench gate structures extending into an inactive cell region of the semiconductor substrate that adjoins the active cell region;
an electrically insulating material covering the plurality of trench gate structures;
first contact openings in the electrically insulating material between adjacent trench gate structures in the active cell region;
second contact openings in the electrically insulating material vertically aligned with the trench gate structures in the inactive cell region;
first counter-doped regions between the adjacent trench gate structures in the active cell region and vertically aligned with the first contact openings;
second counter-doped regions underneath the trench gate structures in the inactive cell region and vertically aligned with the second contact openings;
first contacts in the first contact openings; and
second contacts in the second contact openings.

11. The power semiconductor device of claim 10,
wherein the first contacts and the second contacts are aligned with one another in a lengthwise extension of the first contacts and the second contacts; or
wherein the first contacts and the second contacts are offset from one another in a lengthwise extension of the first contacts and the second contacts.

12. The power semiconductor device of claim 10, further comprising:
a patterned power metallization layer above the electrically insulating material and comprising a first part that contacts the first contacts and a second part that contacts the second contacts; and
a passivation covering any part of the first contacts and the second contacts not covered by the patterned power metallization layer.

13. The power semiconductor device of claim 10, wherein the first contact openings are etched into the semiconductor substrate between the adjacent trench gate structures in the active cell region, and wherein the second contact openings are etched into a gate electrode material of the trench gate structures in the inactive cell region.

14. The power semiconductor device of claim 10,
wherein in the inactive cell region, the plurality of trench gate structures intersect a trench gate bus structure that electrically interconnects a gate electrode material of the trench gate structures, and wherein the power semiconductor device further comprises:
a third contact opening in the electrically insulating material that is vertically aligned with the trench gate bus structure in the inactive cell region; and
a third counter-doped region underneath the trench gate bus structure in the inactive cell region and vertically aligned with the third contact opening; or
wherein the first counter-doped regions and the second counter-doped regions merge with one another along a border region between the active cell region and the inactive cell region.

15. The power semiconductor device of claim 10, further comprising:
a trench shielding structure in the inactive cell region and that laterally surrounds the plurality of trench gate structures, wherein the trench shielding structure is electrically floating;
a third contact opening in the electrically insulating material that is vertically aligned with the trench shielding structure in the inactive cell region; and
a third counter-doped region underneath the trench shielding structure in the inactive cell region and vertically aligned with the third contact opening; and/or
further comprising:
a trench gate bus structure in the inactive cell region;
a third contact opening in the electrically insulating material that is vertically aligned with the trench gate bus structure in the inactive cell region; and
a third counter-doped region underneath the trench gate bus structure in the inactive cell region and vertically aligned with the third contact opening,
wherein a metal line in the trench gate bus structure is electrically connected to gate electrodes in the plurality of trench gate structures.

16. The power semiconductor device of claim 10, wherein a breakdown voltage of the power semiconductor device in the active cell region is in a range of 20V to 60V, wherein the breakdown voltage of the power semiconductor device in the inactive cell region is greater than the breakdown voltage in the active cell region by at least 2V, and wherein a maximum voltage across a gate dielectric insulating material of the plurality of trench gate structures is less than half the breakdown voltage in the inactive cell region; and/or further comprising:
a trench structure in the inactive cell region;
a third contact opening vertically aligned with the trench structure in the inactive cell region; and
a third counter-doped region underneath the trench structure in the inactive cell region and vertically aligned with the third contact opening,
wherein the third counter-doped semiconductor is electrically floating.
